**Europäisches Patentamt**

**European Patent Office**

**Office européen des brevets**

(19)

(11) Veröffentlichungsnummer : **0 499 827 B1**

(12)

# EUROPÄISCHE PATENTSCHRIFT

(45) Veröffentlichungstag der Patentschrift :
**13.12.95 Patentblatt 95/50**

(51) Int. Cl.⁶ : **H03M 3/02,** H04B 1/16,
H03H 17/04, H03H 17/06

(21) Anmeldenummer : **92101157.3**

(22) Anmeldetag : **24.01.92**

(54) **Autoradio mit einer Schaltungsanordnung zur Analog/Digital-Wandlung eines Zwischenfrequenzsignals**

(30) Priorität : **18.02.91 DE 4104882**

(43) Veröffentlichungstag der Anmeldung :
**26.08.92 Patentblatt 92/35**

(45) Bekanntmachung des Hinweises auf die
Patenterteilung :
**13.12.95 Patentblatt 95/50**

(84) Benannte Vertragsstaaten :
**AT DE ES FR GB IT PT**

(56) Entgegenhaltungen :
**WO-A-89/07368**
**GB-A- 2 233 518**

(73) Patentinhaber : **Blaupunkt-Werke GmbH**
**Postfach 77 77 77**
**D-31132 Hildesheim (DE)**

(72) Erfinder : **Vogt, Lothar, Dr.**
**Am Sonnenhang 11**
**W-3156 Hohenhameln (DE)**

## Beschreibung

Die Erfindung geht aus von einem Autoradio nach der Gattung des Hauptanspruchs.

Autoradios werden häufig wie auch andere mobile Funkempfänger unter schlechten Empfangsbedingungen betrieben. Neben einer wechselnden Feldstärke, die insbesondere unter Brücken und in Tunneln extrem geringe Werte annehmen kann, und Mehrwegeempfang beeinträchtigen elektro-magnetische Störfelder die Empfangsqualität. Zur Verarbeitung von gestörten Signalen werden in zunehmendem Maße digitale Schaltungen verwendet, wobei eine möglichst frühzeitige Analog/Digital-Wandlung der empfangenen Signale erwünscht ist, was wiederum Analog/Digital-Wandler für hohe Frequenzen erfordert.

Zur Umwandlung eines Signals in ein digitales Signal werden dem Signal zu äquidistanten Zeitpunkten mit Hilfe eines Abtast-Halte-Gliedes Abtastwerte entnommen. Diese Abtastwerte werden anschließend in Zahlenwerte umgewandelt. Damit die entstehende Zahlenfolge ein kontinuierliches Signal ohne Informationsverlust darstellt, ist die Erfüllung des Abtasttheorems erforderlich, nach welchem die Abtastfrequenz mindestens doppelt so groß wie die höchste im Signal vorkommende Frequenz sein muß. Je höher diese Frequenz ist, desto kürzer ist diejenige Zeit, innerhalb der aus einem Abtastwert ein entsprechender Zahlenwert abgeleitet werden kann.

Diese Forderung ist umso schwerer zu erfüllen, je höher die geforderte Genauigkeit der Analog/Digital-Wandlung ist. Daraus ergibt sich für Analog/Digital-Wandler für hohe Frequenzen ein hoher technischer Aufwand, der für Autoradios nicht tragbar ist. Außerdem ergibt sich bei den bekannten Analog/Digital-Wandlern eine Unsicherheit des Abtast-Zeitpunktes (Jitter), der zu Ungenauigkeiten des Ergebnisses führt.

Es sind ferner sogenannte Sigma-Delta-Wandler bekanntgeworden, welche einen 1-Bit-Datenstrom erzeugen, dessen logischer Pegel davon abhängig ist, ob das zu wandelnde Signal größer oder kleiner als ein aufgrund dieses Vergleichs gewonnenes und anschließend integriertes Signal ist. Diese Wandler sind in ihrem Aufbau sehr einfach, benötigen jedoch eine im Vergleich zur höchsten Signalfrequenz sehr hohe Abtastrate.

Z.B. offenbart Dokument WO 89/07368 einen Radioempfänger, in dem das Zwischensignal durch einen Sigma-Delta-Wandler numerisch umgewandelt wird. Dabei wird die Taktfrequenz des Wandlers als das 32-fache der Zwischenfrequenz gewählt.

Aufgabe der vorliegenden Erfindung ist es, bei einem Autoradio die Analog/Digital-Wandlung eines Zwischenfrequenzsignals, dessen Frequenz üblicherweise recht hoch ist, mit geringem technischen Aufwand zu ermöglichen.

Das erfindungsgemäße Autoradio mit den kennzeichnenden Merkmalen des Hauptanspruchs hat den Vorteil, daß trotz der hohen Frequenz des Zwischenfrequenzsignals ein relativ einfach aufgebauter Sigma-Delta-Wandler verwendet werden kann. Außerdem zeichnet sich bei einem erfindungsgemäßen Autoradio die Schaltungsanordnung zur Analog/Digital-Wandlung durch einen geringen Einfluß von Zeitschwankungen des Abtastsignals aus.

Die Erfindung beruht auf der Erkenntnis, daß bei der Analog/Digital-Wandlung eines Zwischenfrequenzsignals mit Hilfe eines Sigma-Delta-Wandlers eine Unterabtastung möglich ist, da das Zwischenfrequenzsignal eine geringe relative Bandbreite hat und die Abtastrate des Sigma-Delta-Wandlers lediglich größer als das doppelte der absoluten Bandbreite des Zwischenfrequenzsignals zu sein braucht.

Durch die erfindungsgemäße Anwendung des Sigma-Delta-Wandlers allein entsteht in der digitalen Ebene ein neues Zwischenfrequenzsignal, dessen Frequenz gegenüber dem ursprünglichen wesentlich herabgesetzt ist, und das mit weiteren an sich bekannten digitalen Schaltungen in einfacher Weise weiterverarbeitet werden kann.

Obwohl ein bevorzugtes Ausführungsbeispiel auf die Analog/Digital-Wandlung eines frequenzmodulierten Zwischenfrequenzsignals mit einem Träger von 10,7 MHz gerichtet ist, kann auch eine Anwendung auf andere Frequenzen und andere Modulationsarten vorteilhaft sein.

Durch die in den Unteransprüchen aufgeführten Maßnahmen sind vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:

Fig. 1 verschiedene Frequenzspektren, die bei Ausführungsbeispielen des erfindungsgemäßen Autoradios auftreten,

Fig. 2 ein Blockschaltbild eines an sich bekannten Sigma-Delta-Wandlers und

Fig. 3 ein Blockschaltbild einer Schaltungsanordnung zur Analog/Digital-Wandlung in einem erfindungsgemäßen Autoradio.

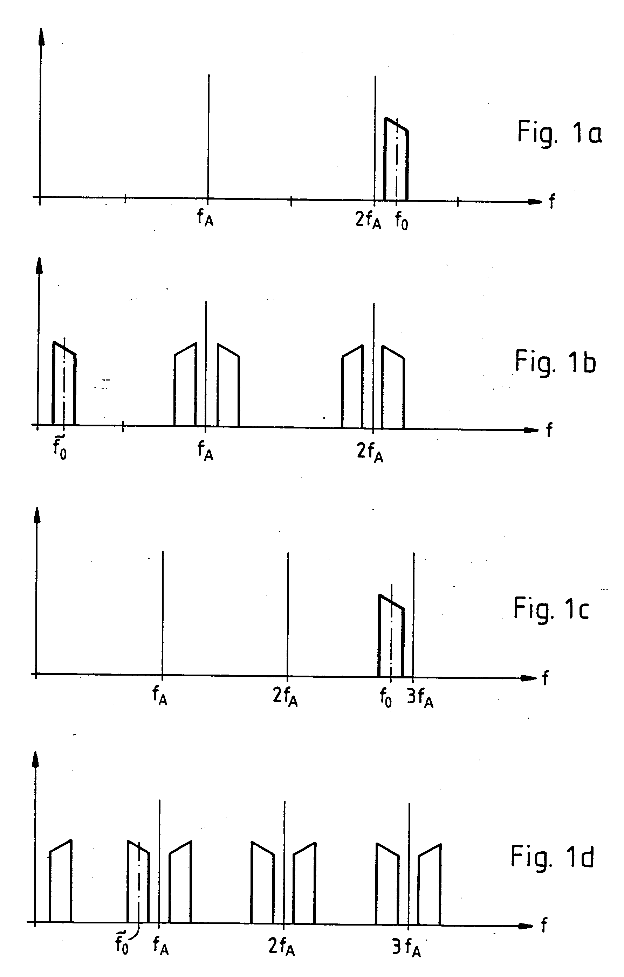

Fig. 1a zeigt das Spektrum des Zwischenfrequenzsignals und die Lage der Abtastfrequenz und deren Vielfachen im analogen Bereich, während Fig. 1b das Spektrum des Ausgangssignals des Sigma-Delta-Wandlers darstellt, wenn das Zwischenfrequenzband oberhalb eines ganzzahligen Vielfachen der Abtastfrequenz liegt.

2

Die Zeitfunktion des Zwischenfrequenzsignals ist durch folgende Gleichung gegeben:

$$u(t) = a(t) \cdot \cos(2\pi f_0 \cdot t + \Phi(t))$$

Dabei ist $f_0$ die Täger- bzw. Mittenfrequenz, a die Amplitude und $\Phi$ ein Phasenwinkel. Im Falle einer Amplitudenmodulation ist $\Phi(t)$ konstant, während bei einer Frequenzmodulation a(t) konstant ist.

Ist $n \cdot f_A < f_0 < (n+1) \cdot f_A$, wobei in der Darstellung nach Fig. 1a $n = 2$ gewählt wurde, so gilt $f_0/f_A = n+R$. Die neue Zwischenfrequenz ist dann $\tilde{f}_0 = R \cdot f_A$. Für $R < 0,5$ gilt $0 < \tilde{f}_0 < f_A/2$, während $f_A/2 < \tilde{f}_0 < f_A$ für $R > 0,5$ gilt. Im Digitalen entsteht also das Signal

$$u(k/f_A) = a(k/f_A) \cdot \cos(2\pi k \, \tilde{f}_0 \, /f_A + \Phi(k/f_A)) \qquad (k \in N)$$

Fig. 1b zeigt ein solches Spektrum für den Fall, daß $R < 0,5$ ist. Bei dem Beispiel eines Zwischenfrequenzsignals für den UKW-Empfang ($f_0 = 10,7$ MHz) und einer Abtastfrequenz von $f_A = 5$ MHz ergibt sich $\tilde{f}_0 = 0,7$ MHz. Um Spektrallinien mit der Abtastfrequenz $f_A$ und deren Vielfachen liegen entsprechende Seitenbänder.

Für den Fall $R > 0,5$, der in Fig. 1c und 1d dargestellt ist, gerät das Zwischenfrequenzsignal als unteres Seitenband der Abtastfrequenz in den Frequenzbereich zwischen $f_A/2$ und $f_A$.

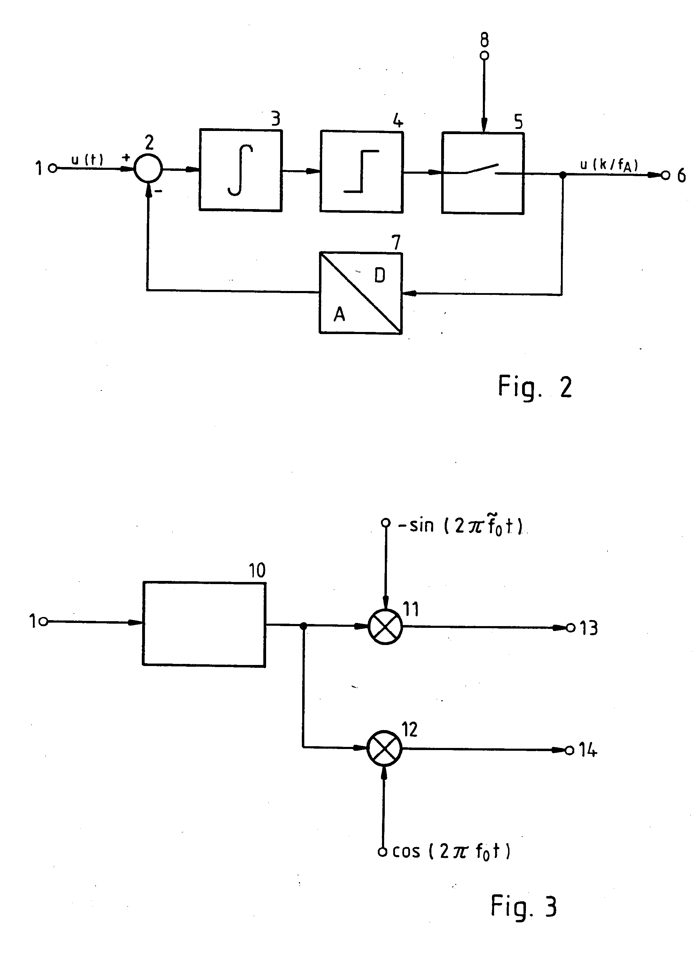

Fig. 2 zeigt ein Blockschaltbild eines an sich bekannten Sigma-Delta-Wandlers. Über einen Eingang 1 wird das zu wandelnde Signal u(t) einer Subtraktionsschaltung 2 zugeführt, deren Ausgang mit einem Integrator 3 verbunden ist. An den Integrator schließt sich eine Schwellwertschaltung 4 an, deren Ausgangssignal über einen steuerbaren Schalter 5 dem Ausgang 6 des Sigma-Delta-Wandlers zugeleitet wird. Außerdem wird das Ausgangssignal u(k/f$_A$) über einen Digital/Analog-Wandler 7 mit einer Breite von einem Bit der Subtraktionsschaltung 2 zugeführt. Der steuerbare Schalter wird mit der Abtastfrequenz $f_A$ gesteuert, die an einen Eingang 8 angelegt wird. Eine genauere Erläuterung der Funktionsweise des Sigma-Delta-Wandlers erübrigt sich, da dieser in der Literatur ausreichend beschrieben wurde, beispielsweise in Motorola APR8/D von 1990.

Fig. 3 zeigt ein Ausführungsbeispiel mit einer an den Sigma-Delta-Wandler 10 anschließenden Mischschaltung, die aus zwei Multiplizierern 11, 12 besteht, denen außer dem Ausgangssignal des Sigma-Delta-Wandlers Signale mit der Frequenz $\tilde{f}_0$ zugeführt werden, die gegeneinander um 90° phasenverschoben sind. An den Ausgängen 13, 14 stehen dann in das Basisband transformierte Signale zur Verfügung, die mit Hilfe eines nicht dargestellten einfachen Amplitudendemodulators demoduliert werden können.

Außer der in Fig. 3 dargestellten Demodulation kann der 1-Bit-Datenstrom vielseitig verarbeitet werden. So kann beispielsweise zunächst nach einer Dezimationsfilterung und einer Abtastratenreduktion zur Erhöhung der Genauigkeit anschließend eine Demodulation erfolgen. Es kann jedoch auch zuerst ein Abmischen ins Basisband wie bei Fig. 3 und anschließend eine Dezimation erfolgen oder eine sofortige Demodulation und anschließend eine Dezimation. Als Demodulatorstruktur ist der sogenannte CORDIC-Algorithmus vorteilhaft, da mit ihm sowohl Phase als auch Amplitude errechnet werden und somit für frequenzmodulierte und amplitudenmodulierte Zwischenfrequenzsignale eine gleichartige Demodulatoreinheit einsetzbar ist.

**Patentansprüche**

1. Autoradio mit einer Schaltungsanordnung zur Analog/Digital-Wandlung eines Zwischenfrequenzsignals, dadurch gekennzeichnet, daß ein Sigma-Delta-Wandler (10) mit einer Taktfrequenz getaktet wird, die derart bemessen ist, daß ein ganzzahliges Vielfaches und ein benachbartes halbzahliges Vielfaches der Taktfrequenz das Frequenzband des Zwischenfrequenzsignals einschließen.

2. Autoradio nach Anspruch 1, dadurch gekennzeichnet, daß bei einer Zwischenfrequenz von 10,7 MHz die Taktfrequenz etwa 5 MHz beträgt.

3. Autoradio nach Anspruch 1, dadurch gekennzeichnet, daß der Ausgang des Sigma-Delta-Wandlers (10) mit einer Mischschaltung (11, 12) verbunden ist, der ein Signal mit der Mittenfrequenz des Zwischenfrequenzsignals zuführbar ist.

4. Autoradio nach Anspruch 3, dadurch gekennzeichnet, daß das Ausgangssignal des Sigma-Delta-Wandlers (10) direkt als 1-Bit-Signal der Mischschaltung (11, 12) zuführbar ist.

5. Autoradio nach Anspruch 3, dadurch gekennzeichnet, daß das Ausgangssignal des Sigma-Delta-Wandlers zunächst in ein mehrere Bit breites digitales Signal umgewandelt und danach der Mischschaltung zugeführt wird.

6. Autoradio nach Anspruch 3, dadurch gekennzeichnet, daß die Mischschaltung von zwei Multiplizierern (11, 12) gebildet ist, welchen außer dem Ausgangssignal des Sigma-Delta-Wandlers (10) die Mittenfrequenz mit einer um 90° gegeneinander verschobenen Phasenlage zugeführt wird.

## Claims

1. Car radio with a circuit arrangement for analogue/digital conversion of the intermediate frequency, characterized in that a sigma-delta converter (10) is clocked with a clock frequency which is dimensioned such that an integral multiple and an adjacent half-integral multiple of the clock frequency enclose the frequency band of the intermediate signal.

2. Car radio according to Claim 1, characterized in that with an intermediate frequency of 10.7 MHz the clock frequency is approximately 5 MHz.

3. Car radio according to Claim 1, characterized in that the output of the sigma-delta converter (10) is connected to a mixing circuit (11, 12) to which a signal can be fed with the centre frequency of the intermediate frequency signal.

4. Car radio according to Claim 3, characterized in that the output signal of the sigma-delta converter (10) can be fed to the mixing circuit (11, 12) directly as a 1-bit signal.

5. Car radio according to Claim 3, characterized in that the output signal of the sigma-delta converter is initially converted into a digital signal which is a plurality of bits wide and is subsequently fed to the mixing circuit.

6. Car radio according to Claim 3, characterized in that the mixing circuit is formed by two multipliers (11, 12) to which, apart from the output signal of the sigma-delta converter (10), the centre frequency is fed with phase angles which are displaced by 90° with respect to one another.

## Revendications

1. Autoradio muni d'un circuit de conversion analogique/numérique d'un signal à fréquence intermédiaire, caractérisé en ce qu'un convertisseur Sigma-Delta (10) est commandé par une fréquence d'horloge dimensionnée pour qu'un multiple entier et un multiple voisin d'une demi-valeur de la fréquence d'horloge, entourent la bande de fréquences du signal à fréquence intermédiaire.

2. Autoradio selon la revendication 1, caractérisé en ce que, pour une fréquence intermédiaire de 10,7 MHz, la fréquence d'horloge est d'environ 5 MHz.

3. Autoradio selon la revendication 1, caractérisé en ce que la sortie du convertisseur Sigma-Delta (10) est reliée à un mélangeur (11, 12) qui reçoit un signal de fréquence centrale du signal à fréquence intermédiaire.

4. Autoradio selon la revendication 3, caractérisé en ce que le signal de sortie du convertisseur Sigma-Delta (10) est appliqué directement comme signal à un bit au mélangeur (11, 12)

5. Autoradio selon la revendication 3, caractérisé en ce que le signal de sortie du convertisseur Sigma-Delta est tout d'abord converti en un signal numérique d'une largeur de plusieurs bits, puis appliqué au mélangeur.

6. Autoradio selon la revendication 3, caractérisé en ce que le circuit mélangeur est formé par deux multiplicateurs (11, 12) qui, outre le signal de sortie du convertisseur Sigma-Delta (10), reçoivent la fréquence centrale avec un déphasage de 90°.

Fig. 1a

Fig. 1b

Fig. 1c

Fig. 1d

Fig. 2

Fig. 3